# EUROPEAN PATENT APPLICATION

(11) **EP 1 068 936 A1**
(43) Date of publication of application: **17.01.2001**
(21) Application number: 00305703.1
(22) Date of filing: 06.07.2000
(51) Int. Cl.: B25J 15/08, B25J 15/00, H01L 21/00, H01L 21/68

(54) **Grippers with ability to change wafer orientation**

(30) Priority: 10.07.1999 US 143232 P
(71) Applicant: APPLIED MATERIALS, INC., Santa Clara, California 95054-3299 (US)
(72) Inventor: Govzman, Boris, Sunnyvale, CA 94086 (US); Volfovski, Leon, Mountain View, CA 94043 (US)
(74) Representative: Bayliss, Geoffrey Cyril

(57) **Abstract**

A gripper/orienter assembly (11) is provided. The gripper/orienter assembly may rotate a substrate (5) between a first orientation and a second orientation as the substrate is being transferred. The gripper/orienter assembly includes a gripper assembly (13A, 13B, 15A, 15B) adapted to support a substrate by the substrate's edge and a rotating mechanism (21, 23) adapted to rotate a substrate between the first orientation and the second orientation.

## Description

The invention relates generally to the field of robotics and more particularly to an apparatus for gripping an object between robotic fingers and rotating the object between a vertical and a horizontal orientation.

A factory for manufacturing semiconductor substrates (e.g., patterned or unpatterned wafers) is conventionally known as a "FAB." Within the FAB, a wafer-handler typically delivers horizontally oriented semiconductor wafers to various fabrication tools. Recently, certain fabrication tools (for example a vertical cleaning tool) may require a semiconductor wafer to be oriented vertically before entering the fabrication tool. Consequently, as the semiconductor wafer exits the fabrication tool, the semiconductor wafer again must be reoriented (or flipped) from a vertical position to a horizontal position.

Accordingly, a need exists for a method and apparatus that may efficiently and cost efficiently flip a semiconductor wafer between a horizontal position and a vertical position.

The present inventors have provided an inventive gripper/orienter assembly that may rotate a substrate between a first orientation and a second orientation. The inventive gripper/orienter assembly comprises a gripper assembly adapted to support a substrate by the substrate's edges and a rotating mechanism, coupled to the gripper assembly and adapted to rotate the gripper assembly between the first orientation and the second orientation. In one aspect, the first orientation may comprise a horizontal position, and the second orientation may comprise a vertical position.

The inventive gripper/orienter assembly may reduce both substrate transfer time and system footprint, as a substrate need not be transferred to and from a location dedicated to substrate orienting.

Other features and aspects of the present invention will become more fully apparent from the following detailed description of the preferred embodiments, with reference to the accompanying drawings in which:
FIGS. 1A-B are a front and a side elevational view, respectively, of an inventive gripper/orienter assembly, shown in a first orientation;
FIGS. 2A-B are a front and a side elevational view, respectively, of the inventive gripper/orienter assembly, shown in a second orientation; and
FIG. 3 is a schematic side elevational view of a vertical cleaner that may employ the inventive gripper/orienter assembly of FIGS. 1A-2B.

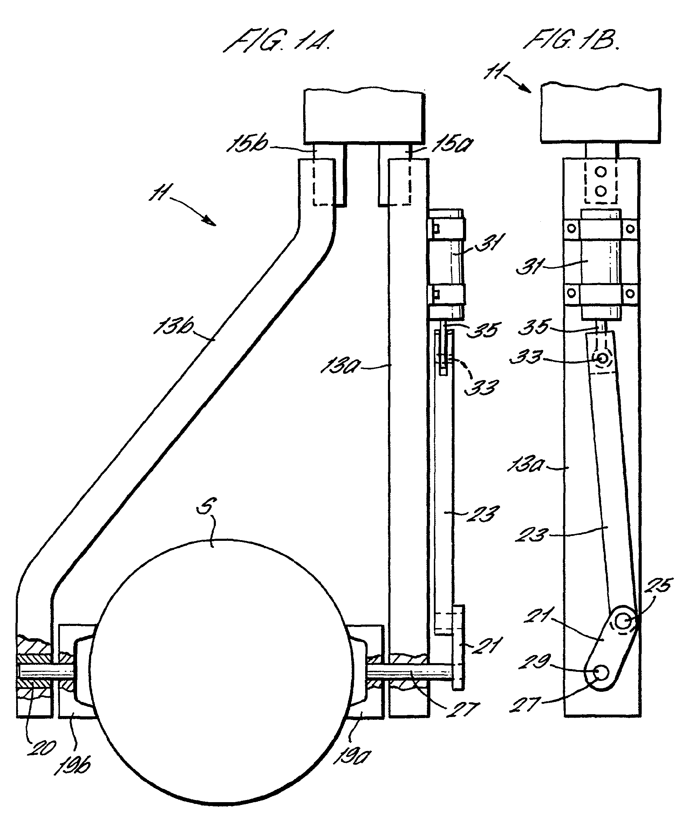

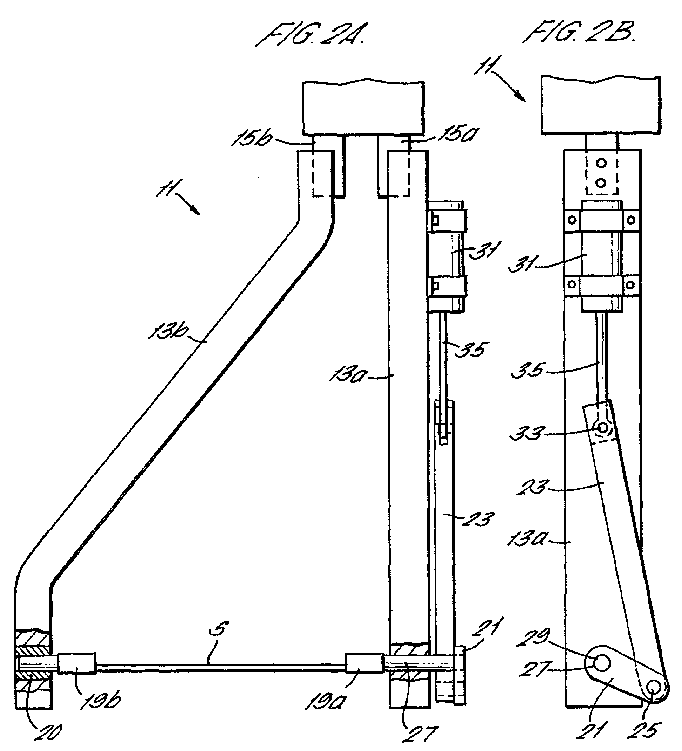

FIGS. 1A-B are a front and a side elevational view, respectively, of an inventive gripper/orienter assembly 11, which show a substrate S in a first orientation. FIGS. 2A-B are a front and a side elevational view, respectively, of the inventive gripper/orienter assembly 11, which show a substrate S in a second orientation. The first orientation may comprise a vertical position, as shown in FIG. 1A, and the second orientation may comprise a horizontal position, as shown in FIG. 2A.

The inventive gripper/orienter assembly 11 comprises a gripper assembly and a rotating mechanism. The gripper assembly comprises a pair of gripper fingers 13a, 13b coupled to a pair of grippers 15a, 15b. The gripper assembly further comprises a pair of end effectors 19a, 19b, adapted to contact a substrate S by its edges, and coupled to the gripper fingers 13a, 13b, respectively. The second gripper finger 13b may comprise a bearing 20 to which the second end effector 19b may be coupled. The bearing 20 allows the second end effector 19b to rotate freely between a vertical position (FIG. 1A) and a horizontal position (FIG. 2A) when the rotating mechanism (described below) causes the first end effector 19a to rotate as described further below.

The rotating mechanism comprises a first lever 21 and a second lever 23. The first lever 21 may be coupled to the second lever 23 via a rotational joint 25. The rotating mechanism further comprises a pivot 27 (e.g., a pin or the like), which may be coupled to the first lever 21 via a fixed joint 29. The fixed joint 29 may be positioned at the first lever 21's central axis of rotation. The pivot 27 is adapted to rotate (e.g., mounted to the gripper assembly via a bearing) and is also coupled to the first end effector 19a so that rotary movement of the first lever 21 will be transferred to the first end effector 19a via the pivot 27.

The second lever 23 may be coupled to an actuator 31, via a moveable joint 33. The actuator 31 (such as a pneumatic cylinder) may have a piston (not shown) and a rod 35 that extends and retracts upon actuation, so as to vertically move the second lever 23, which may be coupled thereto.

The operation of the inventive gripper/orienter assembly 11 is described with reference to the sequential views of FIGS. 1A-B and FIGS. 2A-B, which show a substrate S that pivots from a vertical position (FIG. 1A) to a horizontal position (FIG. 2A) and which show the movement of the rotating mechanism 15 as the substrate S pivots. The end effectors 19a, 19b and the substrate S are initially in the vertical position as shown in FIG. 1A.

In operation, the rod 35 of the actuator 31 extends so as to move the second lever 23 downward. As the second lever 23 moves downward, the first lever 21, which is coupled to the second lever 23, rotates clockwise about its central axis of rotation from a retracted position, as shown in FIG. 1B, to an extended position as shown in FIG. 2B. As the first lever 21 moves to the extended position, the pivot 27, which may be fixedly coupled to the first lever 21, rotates clockwise with the first lever 21. In turn, the first end effector 19a (FIGS. 1A, 2A) that is coupled to the pivot 27, and the substrate S supported thereby, rotate to the horizontal position as shown in FIG. 2A. As the substrate S rotates, the second end effector 19b rotates therewith, via the bearing 20, to the horizontal position as shown in FIG. 2A.

A number of conventional systems exist that may re-orient a semiconductor wafer between a horizontal position and a vertical position. For example, semiconductor wafers are typically re-oriented in a special wafer-re-orienting apparatus (e.g., ex-situ from any fabrication tools being employed). In operation, a wafer-handler delivers the wafer to the wafer-re-orienting apparatus, which re-orients the wafer, and then the wafer-handler delivers the re-oriented wafer to a fabrication tool. Hence, the wafer must be removed from its normal process flow, transferred to the wafer-re-orienting apparatus, re-oriented thereby, and re-introduced to the process flow. Such non-value added time increases the cost per wafer processed.

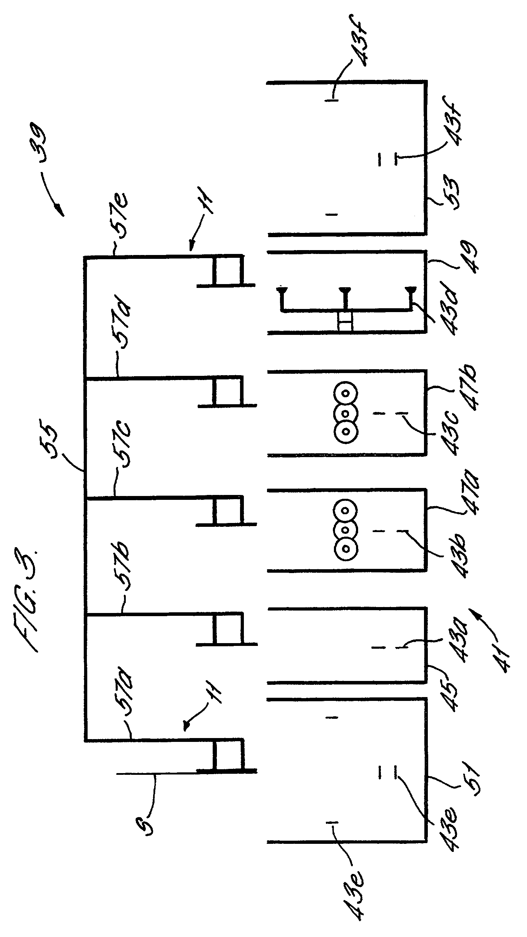

Thus, the present inventors have developed the inventive gripper/orienter 11 that may efficiently and cost effectively rotate a substrate between a horizontal position and a vertical position as the substrate S is moved through a fabrication tool. To fully understand the aspects of the inventive gripper/orienter assembly 11, an exemplary vertical cleaning tool that employs the inventive gripper/orienter assembly 11 is shown and described with reference to FIG. 3.

FIG. 3 is a schematic side elevational view of a vertical cleaner 39 (i.e., a cleaner that supports substrates in a vertical orientation). After a substrate S is polished by a polisher (not shown) that supports substrates in a horizontal orientation, the substrate S enters the vertical cleaner 39 to be cleaned and optionally dried. The vertical cleaner 39 may comprise a plurality of cleaning modules 41, each cleaning module 41 having a substrate support 43a-d that may support a vertically oriented substrate S. The cleaning modules 41 may include a megasonic cleaner module 45, a pair of scrubber modules 47a-b, and a spin-rinse-dryer module 49. The vertical cleaner 39 also may optionally comprise an input module 51 and an output module 53. Both the input module 51 and the output module 53 may have a substrate support 43e, 43f, respectively, that supports a substrate in a horizontal orientation.

A substrate transfer mechanism 55, having a plurality of substrate handlers 57a-e, is movably coupled above the modules 43-53. The substrate handlers 57a-e are positioned to selectively place and extract a substrate to and from the substrate supports 43a-f upon actuation of the substrate transfer mechanism 55. The substrate handlers 57a, 57e which place and extract substrates to and from the input module 51 and the output module 53, respectively, may comprise the inventive gripper/orienter assembly 11. The substrate transfer mechanism 55 is adapted to lift, lower, and to index horizontally forward and backward so as to transfer substrates between the input module 51, the cleaning modules 41, and the output module 53. Specifically, the substrate transfer mechanism 55 may comprise an overhead walking beam-type robot, and the vertical cleaner 39 may be configured as described in U.S. Patent Application Serial No. 09/558,815, filed April 26, 2000 (AMAT No. 3156/CMP/RKK) the entire disclosure of which is incorporated herein by this reference.

In operation, a horizontally oriented substrate S (e.g., which may have been extracted from a "horizontal" polisher) is loaded onto the horizontal substrate support 43e of the input module 51. Upon actuation of the inventive gripper/orienter assembly 11, the substrate handler 57a of the cleaner 39 then assumes the horizontal position (as shown in FIG. 1A) as described previously. Thereafter, the grippers 15a, 15b of the substrate handler 57a move away from each other. As the grippers 15a, 15b move away from each other, the gripper fingers 13a, 13b coupled to the grippers 15a, 15b move away from each other and the end effector 19a, 19b coupled to the gripper fingers 13a, 13b also move away from each other so as to position the gripper orienter assembly 11 of the substrate handler 57a in an open position (e.g., the distance between the end effectors 19a, 19b is slightly greater than the length of the horizontally oriented substrate S).

Upon actuation of the substrate transfer mechanism 55, the substrate handler 57a lowers so as to position the "open" end effectors 19a, 19b adjacent the edges of the horizontally oriented substrate S positioned on the substrate support 43e. Thereafter the grippers 15a, 15b, the gripper fingers 13a, 13b, and the end effectors 19a, 19b move toward each other, so as to position the substrate handler 57a in a closed position (e.g., the distance between the end effectors 19a, 19b is equal to the length of the horizontally oriented substrate S). In the closed position, the substrate handler 57a grasps the horizontally oriented substrate S. Thereafter, the substrate handler 57a, which includes the inventive gripper/orienter assembly 11, re-orients the substrate S from the horizontal position to the vertical position as described below.

Specifically, the rod 25 (FIGS. 1B, 2B) of the actuator 23 retracts so as to move the second lever 23 upward. As the second lever 23 moves upward it causes the first lever 21, which is coupled to the second lever 23, to rotate counterclockwise about its central axis of rotation from the extended position, as shown in FIG. 2B, to the retracted position as shown in FIG. 1B. As the first lever 21 moves counterclockwise to the retracted position, the pivot 27, which is fixedly coupled to the first lever 21, also rotates counterclockwise. In turn, the first end effector 19a, which is coupled to the pivot 27, and the substrate S which is supported in part by the first end effector 19a, rotate to the vertical position as shown in FIG. 1A. As the substrate S rotates, the second end effector 19b rotates therewith via the bearing 20, to the vertical position as shown in FIG. 1A.

While re-orienting the substrate S, the first substrate handler 57a may elevate upon actuation of the substrate transfer mechanism 55, thereby extracting the substrate S from the input module 51, and may index (i.e., move horizontally) to position the substrate S above the megasonic cleaner module 45. Thereafter, the first substrate handler 57a lowers the vertically oriented substrate S into the megasonic cleaner module 45 and places the substrate S on the substrate support 43a. The substrate S is then megasonically cleaned in the DI water bath as is conventionally known.

After the vertically oriented substrate S is megasonically cleaned in the DI water bath, the second substrate handler 57b extracts the substrate S and transfers the substrate S to the first scrubber module 47a for scrubbing, and, thereafter, the third substrate handler 57c transfers the substrate S to the second scrubber module 47b for scrubbing. Within the scrubber modules 47a-b, DI water is sprayed on the substrate S while the scrubber brushes scrub the surface of the substrate S, as is conventionally known.

After cleaning within the scrubber modules 47a-b is complete, the fourth substrate handler 57d extracts the vertically-oriented substrate S and transfers the substrate S to the spin-rinse-dryer module 49. Within the spin-rinse-dryer module 49, the substrate S is rotated at high speed (e.g., 900 RPM) while DI water is sprayed onto the substrate S. After the substrate S is sufficiently rinsed, the DI water spray is turned off and the substrate S is spin-dried.

The fifth substrate handler 57e, which comprises the inventive gripper orienter assembly 11 of FIGS. 1A-2B, extracts the vertically oriented substrate S from the spin-rinse-dryer module 79, horizontally orients the substrate S as previously described, and places the substrate S on the horizontal substrate support 43f of the output module 53. Thereafter the substrate S may be extracted from the vertical cleaner 39 by a substrate handler that handles horizontally oriented substrates, as most conventional FAB's transport substrates in a horizontal orientation.

Because the inventive gripping assembly 11 is employed by the substrate handlers 57a, 57e of the vertical cleaner 39, the substrate S may be re-oriented between the horizontal position and the vertical position as the substrate S is moved through the vertical cleaner 39 (e.g., as the substrate moves between the input or output module and the cleaning modules). Thus, by using the inventive gripper/orienter assembly 11, previously non-value added wafer transport time (e.g., to or from a stand alone re-orienter) may be eliminated. Accordingly, the inventive gripper/orienter assembly 11 may increase wafer throughput.

The foregoing description discloses only the preferred embodiments of the invention, modifications of the above-disclosed apparatus and method which fall within the scope of the invention will be readily apparent to those of ordinary skill in the art. For instance, although described herein as used with a vertical cleaning tool, other apparatuses may require a semiconductor wafer to be re-oriented between a horizontal position and a vertical position and would benefit from use of the inventive gripper/orienter assembly 11. Further, the input and output modules may be eliminated, and substrate handlers that employ the inventive gripper/orienter assembly may pick or place a substrate directly from another substrate handler or from other locations.

The invention may be employed with both pocket type and clamp type gripper assemblies (exemplary grippers are described in commonly assigned U.S. Patent Application Serial No. 09/559,889, filed April 26, 2000 (AMAT No. 3554/CMP/RKK) which is incorporated herein in its entirety by this reference.

Accordingly, while the present invention has been disclosed in connection with the preferred embodiments thereof, it should be understood that other embodiments may fall within the spirit and scope of the invention, as defined by the following claims.

## Claims

1. An apparatus comprising:
a gripper assembly having a pair of end effectors adapted to support a substrate by the substrate's edge; and
a rotating mechanism, coupled to at least one of the pair of end effectors and, adapted to rotate at least one end effector between a first orientation and a second orientation.

2. An apparatus as claimed in claim 1, wherein the rotating mechanism rotates at least one end effector about a substantially horizontal axis.

3. An apparatus as claimed in claim 1 or claim 2, wherein the first orientation comprises a vertical position and the second orientation comprises a horizontal position.

4. An apparatus as claimed in any of claims 1 to 3, wherein the gripper assembly further comprises:
a pair of grippers; and
a pair of gripper fingers, each coupled to one of the grippers;
wherein the pair of end effectors are each coupled to one of the gripper fingers.

5. An apparatus as claimed in any of claims 1 to 4, wherein the rotating mechanism comprises:
a pivot coupled to the at least one end effector;
a first lever coupled to the pivot so that rotation of the lever results in rotation of the pivot;
a second lever rotatably coupled to the first lever;
an actuator coupled to the second lever, the rotating mechanism configured such that movement of the actuator causes at least one of the end effectors, to rotate between a first position and a second position.

6. An apparatus as claimed in claim 5, wherein the pivot is fixedly coupled to both the first lever and a first one of the end effectors.

7. The apparatus of claim 1
wherein the gripper assembly comprises:
a pair of grippers; and
a pair of gripper fingers, each coupled to one of the grippers;
wherein the pair of end effectors are each coupled to one of the gripper fingers; and
wherein the rotating mechanism comprises:
a pivot coupled to at least a first one of the end effectors;
a first lever coupled to the pivot;
a second lever coupled to the first lever;
an actuator coupled to the second lever, the rotating mechanism configured such that movement of the actuator causes a substrate, supported by the gripper assembly, to rotate between a first orientation and a second orientation.

8. An apparatus as claimed in claim 7, wherein the gripper assembly further comprises a bearing coupled between a second one of the end effectors and the respective gripper finger.

9. An apparatus as claimed in claim 7 or claim 8, wherein the pivot is fixedly coupled to both the first lever and a first one of the end effectors.

10. An apparatus as claimed in claim 1, wherein the rotating mechanism is coupled to a first one of the end effectors and the gripper assembly further comprises a bearing coupled between a second one of the end effectors and the respective gripper finger.

11. An apparatus as claimed in claim 10, wherein the first orientation comprises a vertical position and the second orientation comprises a horizontal position.

12. A method comprising:
providing a gripper assembly adapted to support a substrate by the substrate's edge; and
rotating a substrate, supported by the gripper assembly, between a horizontal position and a vertical position.

13. A method as claimed in claim 12, wherein rotating a substrate comprises:
rotating at least a first end effector which supports the substrate.
